# FASCICULE DE BREVET EUROPEEN

(11) **EP 0 963 045 B1**
(45) Date de publication et mention de la délivrance du brevet: **19.09.2001**
(21) Numéro de dépôt: 99401346.4
(22) Date de dépôt: 04.06.1999
(51) Int. Cl.: H03L 7/07

(54) **Générateur utilisant des boucles à verrouillage de phase numérique**
Taktgenerator mit digitalen Phasenregelkreisen
Signal generator using digital phase locked loops

(30) Priorité: 05.06.1998 FR 9807118
(43) Date de publication de la demande: 08.12.1999
(73) Titulaire: STMicroelectronics S.A., 94250 Gentilly (FR)
(72) Inventeur: Lebouleux, Nicolas, 94230 Cachan (FR); Marchand, Benoît, 94230 Cachan (FR); Ianigro, Corinne, 94230 Cachan (FR); Dubois, Nathalie, 94230 Cachan (FR)
(74) Mandataire: Ballot, Paul

(56) Documents cités:
- EP-A- 0 523 953
- US-A- 5 477 177
- US-A- 5 477 181

## Description

La présente invention concerne un dispositif de génération d'un signal de commande déphasé par rapport à un signal de synchronisation externe.

Elle s'applique notamment aux systèmes de traitement des signaux de balayage horizontal dans un moniteur.

Dans une telle application, le signal de synchronisation horizontale reçu par le moniteur a une fréquence comprise habituellement entre 15 et 150 KHz. Le problème est de générer un signal de commande resynchronisé vers le moniteur, déphasé d'une valeur très précise par rapport au signal de synchronisation externe. Quand le dispositif est équilibré, le déphasage comprend une valeur fixe qui ne varie pas de ligne à ligne et une valeur dynamique, qui elle peut changer de ligne à ligne. Cette valeur dynamique correspond en particulier à des variations de balance ou de moiré, et dépendent des caractéristiques de l'application (moniteur). Ce déphasage est habituellement traité par un dispositif analogique qui ne permet pas d'intervenir de façon externe et programmable (par des circuits de l'application) sur ces valeurs, pour modifier les courbes du déphasage. Or, dans des applications courantes, on voudrait ajuster ces courbes de déphasage, en fonction du besoin de l'application.

On a donc chercher à remplacer ce dispositif analogique par un dispositif numérique.

Des circuits à boucles à verrouillage de phase sous forme numérique sont déjà connus. On rappelle qu'en numérique, le déphasage se traduit en pratique par un décalage temporel.

Dans l'invention, il faut d'un part générer à partir d'un signal de synchronisation externe, un signal de référence resynchronisé. Il faut ensuite calculer l'erreur de déphasage entre ce signal de référence et le signal de commande, pour pouvoir corriger ce signal de commande.

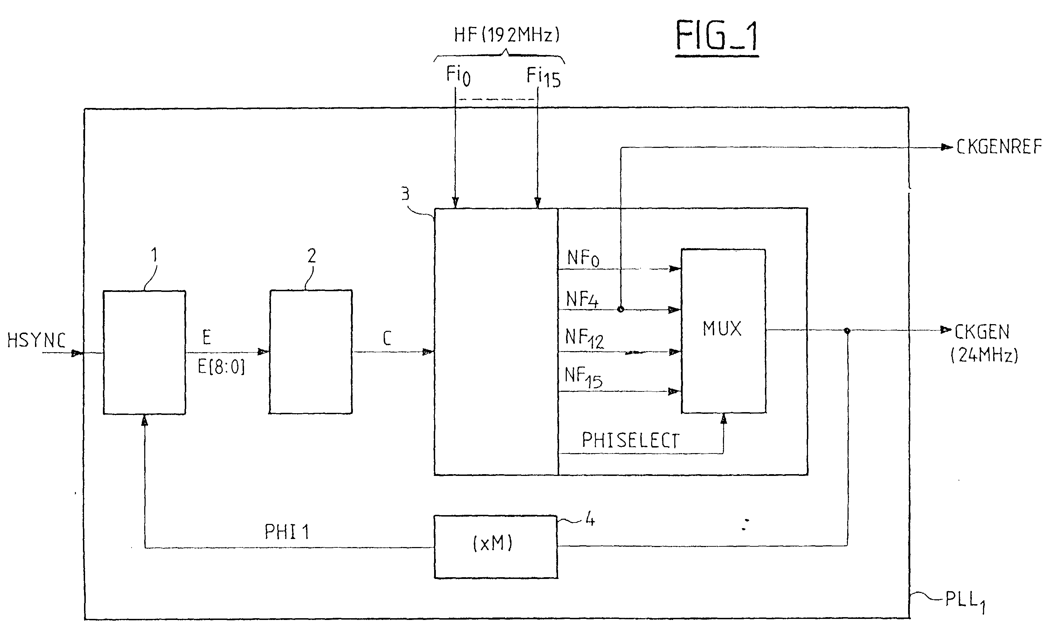

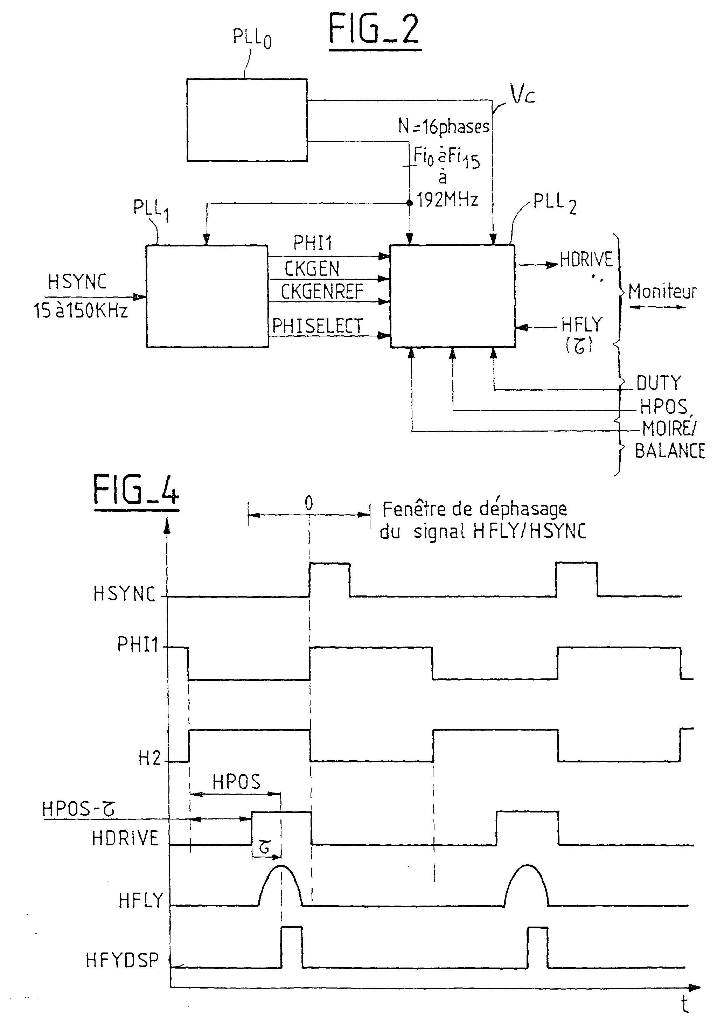

Le signal de référence peut-être obtenu d'une boucle à verrouillage de phase numérique représentée sur la figure 1, et comprenant de manière connue, un comparateur de phase 1 entre le signal de synchronisation externe HSYNC et le signal de référence PHI1 et délivrant en sortie une erreur E signée.

Dans l'exemple, cette erreur E est appliquée sur un intégrateur à filtre numérique 2 qui fournit dans un registre de sortie une information numérique C comprenant une partie entière et une partie fractionnaire. Un tel intégrateur à filtre numérique est par exemple décrit dans la demande EP A 644 654 ayant pour titre "Intégrateur et filtre du premier ordre numériques". On se réfèrera utilement à cette demande pour de plus amples détails sur le fonctionnement de ce circuit.

Ce signal C est appliqué à un synthétiseur de fréquence 3 qui fournit en sortie un signal synthétisé CKGEN. Ce synthétiseur permet de diviser par la valeur entière INT(C) ou par la valeur entière immédiatement supérieure INT(C)+1, les N phases Fi0 et Fi15 d'un signal de haute fréquence F appliquées sur le synthétiseur, selon un principe décrit dans la demande européenne EP 0 641 083 ayant pour titre "Synthétiseur de fréquence", et à laquelle on se réfèrera pour de plus amples détails sur ce circuit.

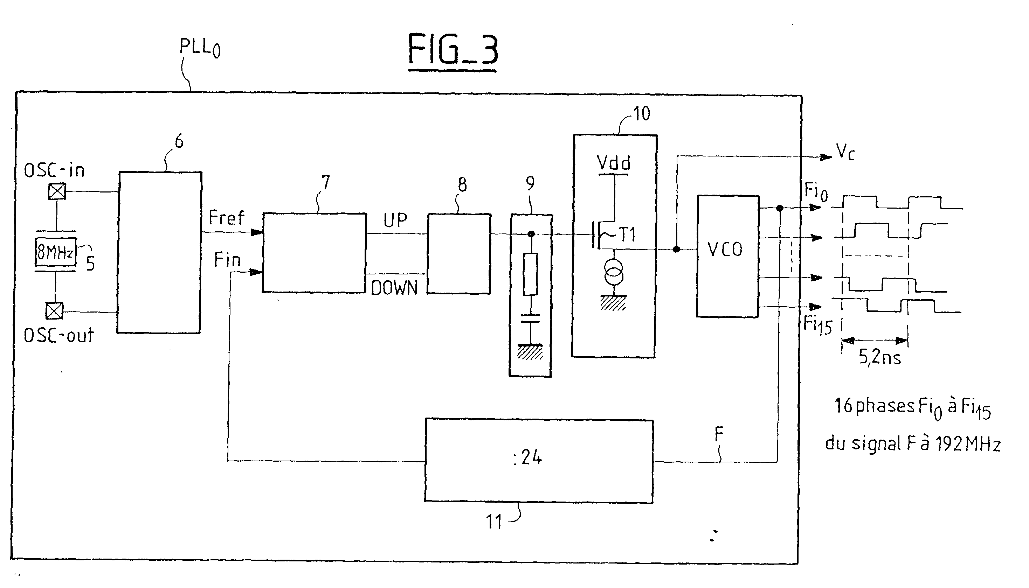

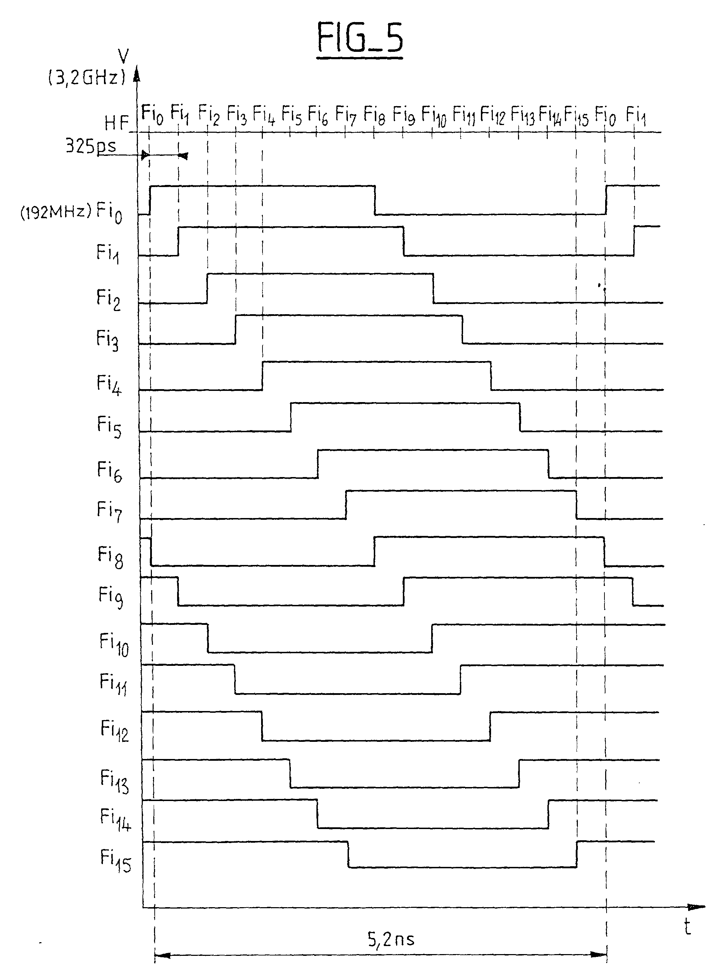

Le signal de haute fréquence F utilisé doit être très stable et est fourni en pratique par une boucle à verrouillage de phase analogique PLL₀ classique représentée sur la figure 3. Dans un exemple pratique, cette boucle PLL₀ permet de fournir les N=16 phases Fi0 à Fi15 du signal haute fréquence F à 192 Mégaherz (Mhz). Ces 16 phases sont représentées sur la figure 5. L'écart entre deux phases consécutives est alors de 325 picosecondes (ps). On obtient ainsi une horloge fictive à très haute fréquence HF, à 3.2 gigaherz (Ghz).

Le synthétiseur comprend un étage de génération du signal synthétisé CKGEN, qui comprend un multiplexeur MUX. Ce multiplexeur reçoit en entrée N signaux de phase NF0 à NF15 et fournit en sortie le signal synthétisé CKGEN.

Le synthétiseur sélectionne la phase parmi les N phases Fi0 à Fi15 du signal haute fréquence F sur laquelle l'accrochage est réalisé. Cette information de sélection de phase est notée PHISELECT. C'est cette information qui commande le multiplexeur MUX. En pratique, la phase d'accrochage peut changer à chaque ligne et le signal CKGEN en sortie présente donc des sauts de phase. Ces sauts de phase ne peuvent pas être supérieurs à l'écart entre deux phases consécutives, dans l'exemple 325 ps.

Ce signal synthétisé CKGEN est rebouclé sur un multiplieur par M, référencé 4 sur la figure 1, pour fournir le signal de référence PHI1 resynchronisé, de même fréquence que HSYNC. Dans l'exemple, on cherche à avoir le signal synthétisé CKGEN à la fréquence de 24 Mhz. Partant d'un signal haute fréquence à 192 Mhz, l'information numérique C est proche de 8 (car 8x24 Mhz = 192 Mhz). On en déduit alors M pour retrouver la fréquence du signal de synchronisation externe HSYNC, tel que la fréquence du signal synthétisé CKGEN soit égale à M fois la fréquence de HSYNC. La sortie du multiplieur donne le signal resynchronisé PHI1. Ce signal issu du signal CKGEN peut présenter, comme lui des sauts de phase. Pour chaque ligne, la phase courante d'accrochage correspondante est la même que celle du signal CKGEN. C'est donc celle définie par l'information PHISELECT.

Dans l'invention, on cherche plus particulièrement à faire la correction de déphasage par un circuit numérique, apte à travailler à très haute fréquence, donc apte à effectuer des corrections de déphasage très fines, de manière à obtenir en sortie un signal de commande resynchronisé et déphasé d'une valeur HPOS avec une précision très fine, par rapport au signal de synchronisation externe HSYNC. Cette valeur HPOS est déterminée par programmation, et commandée par des circuits de l'application considérée.

Pour obtenir cette précision dans le déphasage, on utilise le signal de haute fréquence F à 192 MHZ fourni par la boucle à verrouillage de phase analogique PLL₀ et le signal de référence PHI1 fourni par la première boucle à verrouillage de phase numérique PLL1.

Cependant, on a vu que ce signal de référence PHI1 présente des sauts de phase.

Si on part du signal de référence PHI1 pour mesurer et corriger le déphasage du signal de commande, il faut donc tenir compte, à chaque nouvelle ligne, de la phase courante d'accrochage dans la boucle PLL₁, sur laquelle ce signal de référence PHI1 s'est resynchronisé, pour faire une mesure d'erreur correcte. Or la prise en compte de ces sauts de phase est très pénalisante en temps.

En outre, on a vu que l'on cherche à mesurer l'erreur à 325 picosecondes près entre ce signal de référence PHI1 et le signal de commande, en tenant compte de la valeur programmée HPOS, puisque l'on cherche à avoir un déphasage à l'équilibre entre ce signal de commande et le signal de référence égal à HPOS. Le signal d'erreur doit être précis à 325 ps.

Or, si on utilise un comparateur de phases, il faut qu'il permette à la fois une telle résolution et une telle précision. Cela impose en pratique de fortes contraintes sur ce comparateur.

Enfin, la mesure d'erreur fournie par le comparateur de phase devrait encore être échantillonnée, pour connaître de combien de cycles du signal de très haute fréquence HF à 3.2Ghz est le déphasage (nombre de cycles de 325 ps). Or en faisant l'échantillonnage à cette très haute fréquence, on fait alors nécessairement une erreur d'un quantum par front du signal d'erreur.

Une solution à ces différents problèmes techniques liés à cette mesure d'erreur a été trouvée dans un dispositif comprenant une boucle à verrouillage de phase numérique pour asservir un signal de commande par référence à ce signal de référence PHI1 et comprenant un circuit de mesure du déphasage, un circuit de calcul numérique du déphasage à effectuer et un circuit de déphasage.

Selon l'invention, le circuit de mesure comprend un premier circuit de mesure grossière du déphasage entre le signal de commande ou un signal dérivé retardé et le signal de référence, contrôlé par une phase fixe PHIREF du signal de haute fréquence F, indépendante de la phase courante d'accrochage dans la boucle PLL₁, le décalage entre cette phase fixe et la phase courante étant prise en compte ultérieurement de façon numérique.

De cette manière, on n'est plus gêné par les sauts de phase du signal PHI1.

Dans un mode de réalisation, le circuit de mesure grossière comprend des moyens pour recaler le signal de référence par rapport à une phase fixe du signal synthétisé CKGEN correspondant à la phase fixe PHIREF du signal haute fréquence F, et un circuit de comptage à préchargement déclenché par le signal de référence recalé, et préchargé à une valeur théorique fournie par le circuit de calcul numérique CCN, pour compter ou décompter à la cadence de la phase fixe haute fréquence PHIREF, le comptage étant inhibé par un front actif du signal de commande ou du signal dérivé retardé. La sortie du compteur fournit la mesure grossière attendue en sortie.

De préférence, le circuit de mesure comprend en outre un circuit de mesure fine comprenant des moyens pour mémoriser l'état des N phases du signal haute fréquence F sur un front actif du signal de commande, et des moyens pour déterminer la phase sur laquelle ledit front du signal de commande ou du signal dérivé, retardé est arrivé, l'information correspondante fournissant la mesure fine attendue en sortie.

Le circuit de calcul numérique fournit en sortie une information de déphasage grossier et fin, dont une valeur statique est déterminée en fonction des mesures grossières et fine, de la valeur programmée HPOS et du décalage existant entre la phase fixe et la phase courante de synchronisation. Cette information peut avoir une valeur dynamique fonction de commandes externes de déphasage dynamique, typiquement de balance et de moiré.

La boucle de verrouillage numérique selon l'invention permet en outre de traiter une information de rapport cyclique externe dans le circuit de déphasage. On peut ainsi faire varier ce rapport cyclique selon le besoin.

Telle que caractérisée, l'invention concerne donc un dispositif de génération d'un signal de commande déphasé par rapport à un signal de synchronisation externe, comprenant une première boucle à verrouillage de phase numérique pour fournir un signal de référence asservi au signal de synchronisation externe par une phase courante parmi N phases d'un signal de haute fréquence, caractérisé en ce qu'il comprend une deuxième boucle à verrouillage de phase numérique comprenant un circuit de mesure de la position d'un front actif du signal de commande ou d'un signal dérivé retardé par rapport à un front actif du signal de référence, un circuit de calcul du déphasage à effectuer et un circuit de déphasage, et en ce que le circuit de mesure comprend un circuit de mesure grossière de ladite position, contrôlé par une phase fixe du signal de haute fréquence indépendante de la phase courante d'accrochage dans la première boucle, le circuit de calcul numérique comprenant des moyens pour prendre en compte le décalage entre ladite phase fixe et ladite phase courante.

D'autres caractéristiques et avantages de l'invention sont donnés dans la description suivante, en référence aux dessins annexés, dans lesquels :
- la figure 1 représente un schéma fonctionnel d'une boucle à verrouillage de phase numérique PLL₁ de l'état de la technique pour fournir un signal de référence PHI1 à partir d'un signal de synchronisation horizontale externe HSYNC,
- la figure 2 représente un bloc diagramme général d'un dispositif selon l'invention,
- la figure 3 représente un schéma fonctionnel d'une boucle à verrouillage de phase analogique PLL₀ utilisée dans l'invention,
- la figure 4 représente la forme des différents signaux utilisés ou générés dans le dispositif selon l'invention représenté sur la figure 2,
- la figure 5 représente la forme des N phases Fi0 à Fi15 du signal de haute fréquence F et le signal d'horloge fictif très haute fréquence résultant HF,
- la figure 6 représente un schéma fonctionnel d'une boucle à verrouillage de phase numérique PLL₂ selon l'invention pour mesurer l'erreur et calculer et effectuer le déphasage entre le signal de référence et le signal de commande,
- la figure 7 représente les signaux relatifs au fonctionnement du circuit de mesure grossière de la boucle PLL₂ de la figure précédente,
- la figure 8 représente un schéma détaillé du circuit de détection fine de l'erreur de la boucle PLL₂ de la figure précédente,
- la figure 9 représente les signaux correspondant à la réalisation du déphasage grossier et du rapport cyclique par le circuit correspondant de la boucle PLL₂,
- la figure 10 est un schéma de principe de la réalisation du déphasage fin et
- la figure 11 montre un schéma détaillé d'une cellule à retard du circuit de déphasage fin.

La figure 2 représente un schéma-bloc général d'un dispositif de génération d'un signal de commande HDRIVE déphasé par rapport à un signal de synchronisation externe HSYNC selon l'invention.

Ce dispositif comprend une boucle à verrouillage de phase analogique, noté PLL₀, une première boucle à verrouillage de phase, notée PLL₁ déjà décrite en partie et représentée sur la figure 1 et une deuxième boucle à verrouillage de phase, notée PLL₂.

Un exemple pratique de réalisation du premier circuit PLL₀ est représenté sur la figure 3. Il comprend un oscillateur 5 à quartz, pour fournir une fréquence de référence. Dans l'exemple le signal de sortie à une fréquence de 8MHz. Ce signal est remis en forme dans un étage d'entrée 6 pour fournir un signal FREF de fréquence 8MHz.

Le circuit ALL₀ comprend ensuite, de façon classique, un comparateur de phase 7, suivi d'un circuit de pompe de charge 8, d'un filtre passe-bas 9, de type RC, et d'un oscillateur commandé en tension, VCO, dont la sortie est rebouclée sur le comparateur de phase par un diviseur de fréquence 11.

Un circuit 10 comprenant un transistor T1 polarisé en courant entre la tension d'alimentation positive Vdd et la masse, et commandé sur sa grille par la sortie du filtre 9, fournit une tension de commande Vc. C'est cette tension de commande qui est appliquée au circuit VCO.

Selon l'invention, cette tension de commande Vc est également appliquée à la deuxième boucle PLL₂, pour des raisons qui seront expliquées avec le fonctionnement de cette boucle.

Le circuit VCO fournit en sortie les N phases Fi0 à Fi15 d'un signal haute fréquence F. Dans l'exemple ce signal F a une fréquence de 192 Mhz. Comme on l'a déjà vu ci-dessus et comme représenté sur la figure 5, avec N=16 phases Fi0 à Fi15 à 192 Mhz, on obtient une horloge fictive HF très haute fréquence à 3.2 Ghz. Ces 16 phases vont permettre, comme on le verra plus loin, d'obtenir une résolution très fine de 325 ps.

Dans cet exemple, le diviseur 11 est un diviseur par 24.

Les N=16 phases Fi0 à Fi15 du signal haute fréquence F à 192 Mhz sont appliquées à chacune des boucles à verrouillage de phase numérique PLL₁ et PLL₂ utilisées dans le dispositif selon l'invention.

La première boucle Pll₁ reçoit ainsi ces N=16 phases Fi0 à Fi15, et un signal de synchronisation externe HSYNC, qui est le signal de synchronisation horizontale pour l'application qui nous intéresse plus particulièrement.

Cette boucle PLL₁ a déjà été décrite en référence à la figure 1. Elle fournit en sortie un signal de référence PHI1 asservi à ce signal de synchronisation externe sous contrôle des N phases Fi0 - Fi15 du signal de haute fréquence F (192 Mhz). Cette boucle comprend un synthétiseur 3, duquel on obtient un signal synthétisé CKGEN, de fréquence intermédiaire, dans l'exemple de 24 Mhz ainsi que N signaux de phase NF0 à NF15 de ce signal synthétisé, par division de fréquence des N phases Fi0 - Fi15 du signal de haute fréquence F. Enfin, cette boucle PLL1 génère en interne une information de sélection PHISELECT de la phase courante d'accrochage, sur laquelle, à un moment donné (en pratique, pour une ligne), les signaux de référence PHI1 et synthétisé CKGEN sont synchronisés. On a vu que cette phase courante d'accrochage peut changer à chaque ligne.

Selon l'invention, cette information de sélection de phase courante de synchronisation, PHISELECT, le signal synthétisé CKGEN et une phase fixe CKGENREF de ce signal synthétisé sont appliqués en entrée de la deuxième boucle PLL₂, en plus du signal de référence PHI1.

Ces signaux supplémentaires vont permettre en pratique d'une part la mesure du déphasage par rapport à une phase fixe et d'autre part la prise en compte du décalage entre la phase fixe et la phase courante d'accrochage dans la boucle PLL₁ dans le calcul numérique du déphasage à effectuer.

La deuxième boucle à verrouillage de phase numérique PLL₂ selon l'invention comprend 3 circuits ayant chacun une fonction différente : un circuit CME de mesure d'erreur qui remplace le comparateur de phase habituellement utilisé ; un circuit CCN de calcul numérique du déphasage à effectuer ; et un circuit de déphasage CD proprement dit.

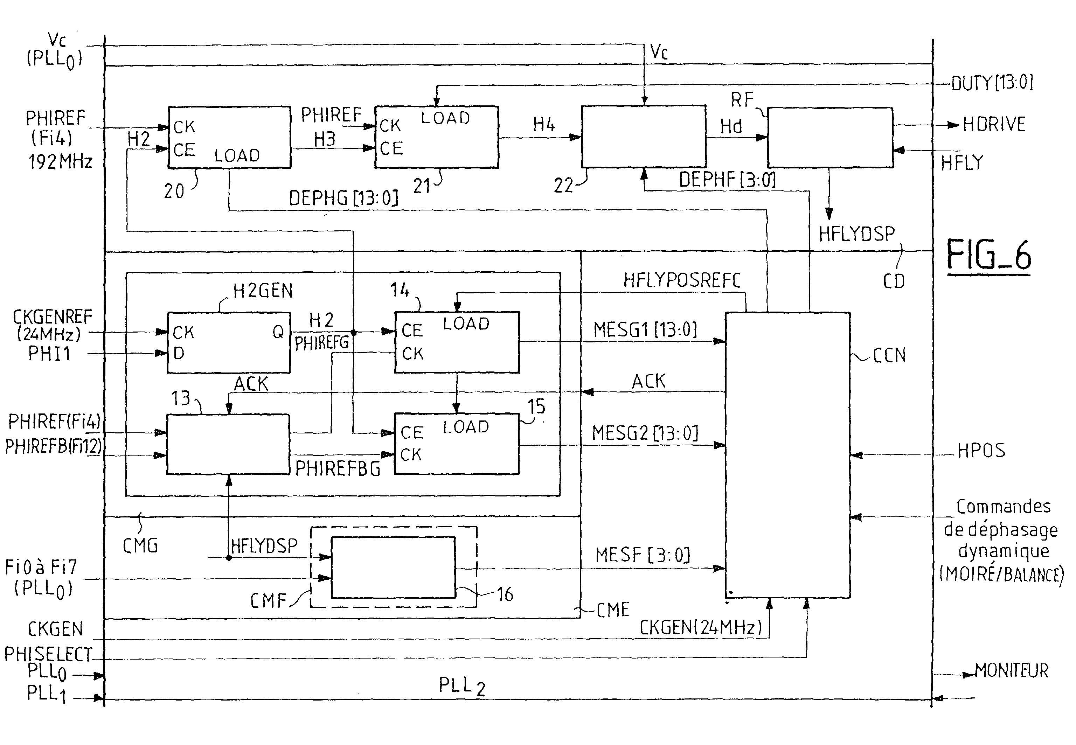

Avant de détailler cette boucle dont un exemple de réalisation est détaillé sur la figure 6, nous allons décrire en relation avec la figure 4 un exemple des différents signaux mis en oeuvre.

Dans cet exemple, on a ainsi représenté le signal de synchronisation externe HSYNC appliqué en entrée de la boucle PLL₁ et le signal de référence PHI1 délivré en sortie de cette boucle : c'est un signal synchrone du signal HSYNC. Dans l'exemple, son rapport cyclique est de 50%.

Le signal HDRIVE est le signal de commande délivré en sortie par la deuxième boucle PLL₂.

Dans une application particulière de l'invention, ce signal de commande HDRIVE est envoyé au moniteur qui le renvoie sous forme d'un signal HFLY représenté sur la figure 4. Ce signal HFLY présente un retard Δ par rapport au signal de commande HDRIVE.

Dans cette application particulière, c'est ce signal dérivé retardé que la boucle PLL2 doit asservir. C'est donc ce signal dont on mesure la position par rapport au signal de référence PHI1 dans le circuit de mesure CMN. Mais le principe de l'invention s'appliquerait aussi bien directement au signal HDRIVE.

Dans la suite, on s'attache à la description d'un mode de réalisation de la boucle PLL₂ dans cette application particulière.

Dans la suite, on considère comme front actif le front montant des signaux considérés.

Dans l'application particulière vue ci-dessus, on voit sur la figure 4 que le déphasage programmé HPOS que l'on cherche à obtenir, c'est le déphasage entre ce signal dérivé HFLY du signal de commande HDRIVE et retardé de Δ, par rapport au signal de référence. Dans l'exemple représenté, ce déphasage programmé est tel que l'on ait une avance de phase du signal dérivé retardé HFLY par rapport au signal de référence PHI1.

Pour être utilisable par le circuit de mesure, le signal dérivé retardé est remis en forme par un circuit RF de la boucle PLL₂, afin d'obtenir un signal HFLYDSP, présentant des impulsions toujours positives quelle que soit la polarité du signal HFLY. Cette polarité dépend de moniteur. Dans l'exemple représenté, cette polarité est positive.

Pour l'application particulière décrite, la mesure d'erreur est donc effectuée par rapport à ce signal HFLYDSP, qui est aussi un signal dérivé du signal de commande et retardé de Δ. Dans une autre application, la mesure d'erreur pourrait se faire directement par rapport au signal de commande HDRIVE.

Le circuit de mesure numérique CMN comprend un circuit de mesure grossière CMG, qui, selon l'invention, travaille par rapport à une phase fixe PHIREF du signal de haute fréquence F à 192 Mhz, indépendante de la phase d'accrochage dans la boucle PLL₁. Le décalage entre cette phase fixe et la phase courante est traité dans le circuit de calcul numérique CCN.

Dans l'exemple la phase fixe haute fréquence PHIREF est la phase Fi4.

En pratique, on verra que l'on utilise aussi la phase fixe CKGENREF correspondante du signal synthétisé CKGEN. Dans l'exemple, la phase fixe CKGENREF est donc égale à la phase NF4. Ces phases fixes fournies par les boucles PLL₀ et PLL₁, et la phase complémentaire haute fréquence PHIREFB, égale à Fi12 dans l'exemple, sont donc appliquées en entrée au circuit de mesure grossière CMG.

Selon l'invention, le circuit de mesure grossière CMG comprend des moyens H2GEN pour fournir un signal de référence recalé par rapport à une phase fixe CKGENREF parmi les N phases NF0,...NF15 du signal synthétisé CKGEN correspondant à la phase fixe PHIREF du signal de haute fréquence F et un premier circuit de comptage à préchargement 14, préchargé à une valeur de position théorique HFLYPOSREFC fournie par le circuit de calcul numérique CCN, déclenché par le signal de référence recalé H2, pour compter ou décompter à la cadence de la phase fixe de haute fréquence CKGENREF, le comptage ou le décomptage étant inhibé par un front actif du signal de commande HDRIVE ou du signal dérivé HFLYDSP, la sortie du compteur fournissant une première mesure grossière MESG1.

Le signal de référence recalé H2 ne présente donc plus de sauts de phase.

Dans l'exemple, le circuit de recalage consiste en une bascule recevant sur son entrée D, le signal de référence PHI1, sur son entrée horloge CK, la phase fixe CKGENREF du signal synthétisé, de fréquence 24 Mhz et fournissant en sortie Q, le signal recalé H2. Dans l'exemple, et comme représenté sur la figure 4, ce signal recalé H2 est en outre en opposition de phase avec le signal de référence PHI1. Ceci va permettre de générer un signal dérivé retardé HFLY avant ou après le front montant du signal de synchronisation externe HSYNC. Dans l'exemple représenté sur cette figure, le signal HFLY est généré avant le front montant du signal HSYNC.

Pour commander l'inhibition du décomptage, le circuit de mesure grossière CMG comprend dans l'exemple représenté un circuit de fenêtrage 13, qui reçoit en entrée la phase fixe haute fréquence PHIREF (=Fi4 dans l'exemple), sa phase complémentaire haute fréquence PHIREFB (=Fi12 dans l'exemple), le signal dérivé HFLYDSP et un signal d'état ACK, issu du circuit de calcul numérique CCN.

Ce circuit génère en sortie un signal d'horloge PHIREFG issu de la phase fixe haute fréquence PHIREF et un signal d'horloge complémentaire PHIREFBG, issu de la phase complémentaire PHIREFB.

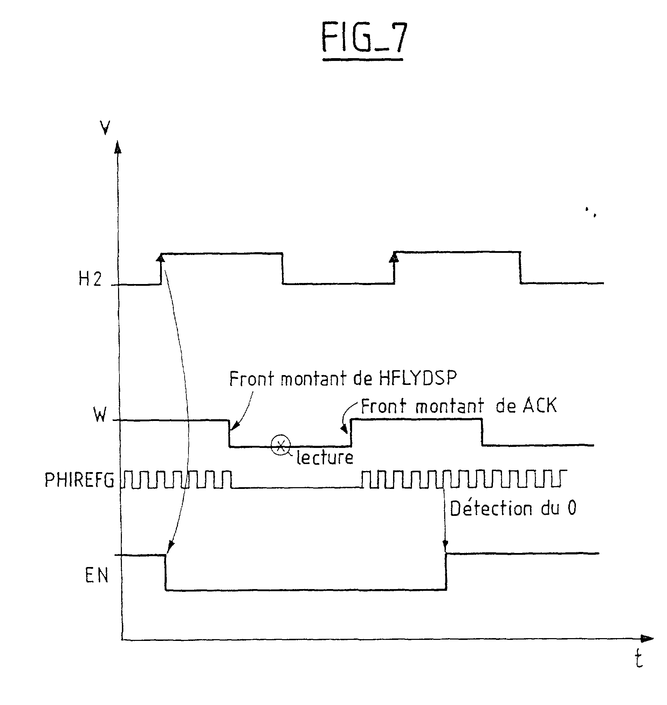

Le signal PHIREFG obtenu est représenté sur la figure 7. Ce signal est la recopie de la phase fixe PHIREF, mais invalidée dans une fenêtre W comprise entre le front montant du signal HFLYDSP et le front montant du signal d'état ACK.

Le circuit de mesure grossière comprend en outre un premier compteur à préchargement 14, qui dans l'exemple fonctionne en décomptage. De préférence, il comprend un deuxième compteur à préchargement 15, qui dans l'exemple fonctionne en décomptage.

Ces compteurs reçoivent en entrée horloge CK, le premier, 14, le signal PHIREFG, et le second, 15, le signal PHIREFBG.

Les compteurs 14 et 15 reçoivent en outre chacun, sur leur entrée CE de déclenchement du décomptage, le signal recalé H2 et sur une entrée de préchargement LOAD, une valeur HFLYPOSREFC, fournie par le circuit de calcul numérique CCN et correspondant à la position théorique calculée du front montant du signal HFLYDSP.

En sortie de ces compteurs, on obtient la position grossière, en nombre de cycles de 5.2 ns (correspondant à la fréquence horloge de 192 Mhz appliquée sur CK), du front montant de HFLYDSP par rapport à cette position théorique.

Le fonctionnement des deux compteurs est identique. Il est expliqué en relation avec la figure 7, qui se rapporte au compteur 14.

On a vu que le signal appliqué comme horloge CK, est la recopie de la phase fixe PHIREF sauf dans une fenêtre W où elle est inhibée. Le début de la fenêtre correspond au front montant du signal HFLYDSP.

Ainsi, le décomptage dans le compteur 14 est validé par le front montant du signal recalé H2. Le signal de validation EN du compteur est activé. Le décomptage part donc de la valeur préchargée, HFLYPOSREFC et est effectué à la cadence du signal PHIREFG, c'est à dire toutes les 5.2 ns. Ce décomptage est stoppé sur l'arrivée front montant du signal HFLYDSP. Le circuit de calcul CCN peut alors venir lire la valeur de sortie MESG1 stabilisée sur le compteur 14. Cette valeur correspond à la mesure grossière, en nombre de cycles de 5.2 ns correspondant à la fréquence horloge (192 Mhz), de la position du signal HFLYDSP par rapport au signal recalé H2.

Le compteur peut ensuite être ré-initialisé. Dans l'exemple représenté, cette ré-initialisation s'effectue par la reprise du décomptage jusqu'à zéro. A cet effet, le circuit de calcul numérique active le signal d'état ACK. C'est la fin de la fenêtre W. Le décomptage reprend.

Quand on atteint zéro, un circuit de détection du zéro dans le compteur inactive le signal de validation EN. A partir de ce moment, et jusqu'au prochain front actif de validation du signal H2, le compteur peut prendre en compte une nouvelle valeur de chargement envoyée par le circuit de calcul numérique CCN.

Le compteur 15 fonctionne de la même manière, mais cadencé sur la phase complémentaire. Ce deuxième compteur 15 est utilisé en prévision du cas où le front montant du signal HFLYDSP serait autour du front montant du signal d'horloge PHIREFG. Il fournit en sortie une valeur de mesure grossière MESG2.

Le circuit de calcul numérique lit ces deux valeurs MESG1 et MESG2, et détermine ensuite la valeur à prendre en compte. Dans l'invention, cette détermination se fait à partir du résultat d'une mesure fine.

En effet, pour avoir la précision recherchée dans l'invention, on prévoit d'effectuer en plus de la mesure grossière basée sur une phase fixe du signal de haute fréquence F à 192 Mhz, une mesure fine basée sur la très haute fréquence HF (3.2Ghz).

Selon l'invention, cette mesure fine est obtenue en mémorisant l'état des phases Fi0 à Fi15 sur le front actif, montant du signal HFLYDSP. Ceci permet de déterminer la phase sur laquelle est arrivée ce front montant avec une erreur inférieure à 325 ps.

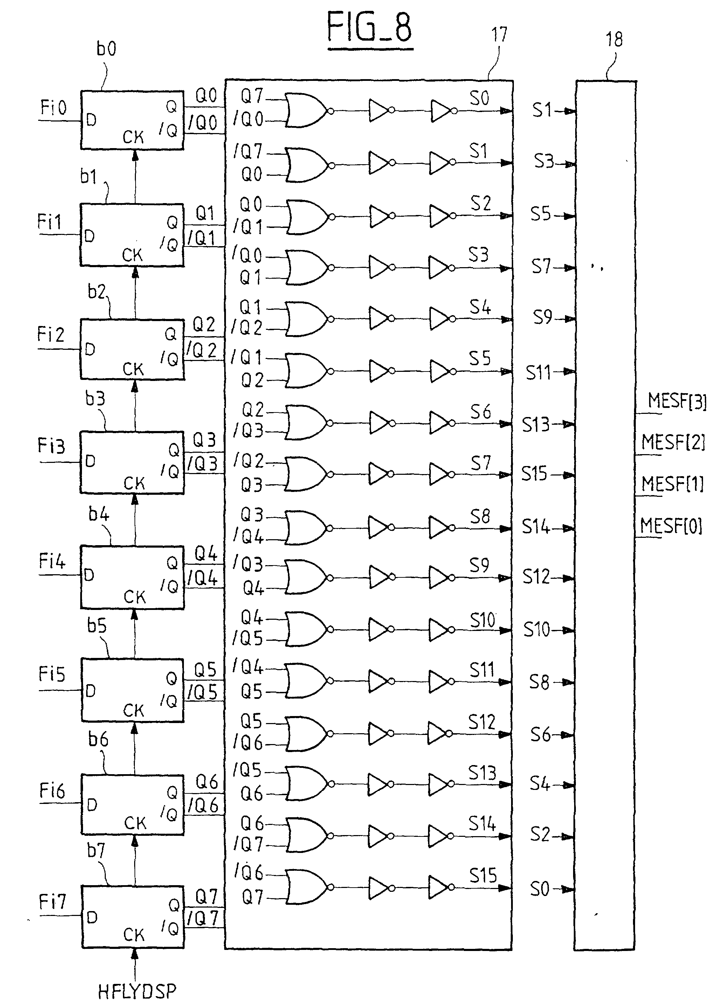

Le circuit de mesure fine CMF selon l'invention est détaillé sur la figure 8. Il comprend des moyens de mémorisation de l'état 0 ou 1 des phases du signal haute fréquence F sur le front du signal HFLYDSP.

Dans l'exemple, ces moyens de mémorisation sont des bascules.

Dans cet exemple, on ne prend en compte que la moitié des phases, dans l'exemple, les huit premières phases Fi0 à Fi7, chacune appliquée sur l'entrée D d'une bascule respective, b0 à b7. Le signal HFLYDSP est appliqué sur l'entrée horloge de ses bascules. En utilisant les sorties directes Q0 à Q7 et /Q0 à /Q7, on obtient l'état des 16 phases Fi0 à Fi15 sur le front montant de ce signal.

Si on se réfère à la figure 5 représentant les 16 phases, on voit que nécessairement, on aura soit les sorties Q0 à Qi toutes à 0 et les sorties suivantes Qi+1 à Q7 toutes à 1, soit le contraire (Q0 à Qi à 1 et Qi+1 à Q7 à 0). Il s'agit de détecter où se produit la transition 0 vers 1 ou 1 vers 0.

En faisant suivre ces bascules d'un circuit de décodage 17, à base de portes logiques, on effectue cette identification à partir des sorties directes Q0 à Q7 et complémentaires /Q0 à /Q7.

On récupère en sortie 16 signaux logiques S0 à S15, dont un seul est 1, correspondant à la phase sur laquelle est arrivé le front montant du signal HFLYDSP. Un circuit d'encodage 18 fournit en sortie l'information de mesure fine MESF, dans l'exemple sur 4 bits.

Le circuit de calcul numérique CCN calcule la correction de déphasage à partir des mesures faites sur la ligne courante, pour l'appliquer à la ligne suivante au moyen du circuit de déphasage CD. Ce circuit fonctionne à la cadence du signal synthétisé CKGEN (24 Mhz). Il comprend des moyens de calcul de la position de référence HFLYPOSREFC, des moyens de comparaison numérique, un accumulateur et un circuit de gestion des déphasages dynamiques.

Le calcul de l'erreur est effectué en faisant une comparaison numérique des mesures grossières MESG1, MESG2 et fine MESF, avec la valeur de référence HFLYPOSREFC.

Cette valeur de référence correspond en pratique à la valeur programmée HPOS, en tenant compte du décalage existant entre le signal de référence PHI1 et le signal recalé H2, décalage qui peut varier à chaque ligne. Ce décalage est donné par l'information PHISELECT de sélection de la phase de synchronisation courante dans la boucle PLL₁.

Le résultat de la comparaison donne l'erreur signée que l'on ajoute au contenu de l'accumulateur.

Quand la boucle PLL₂ est équilibrée, cet accumulateur contient la valeur égale à HPOS - Δ (dans le cas d'une application utilisant le signal HDRIVE directement, appliqué au circuit de mesure de la boucle, cette valeur serait égale simplement à HPOS).

A cette correction de déphasage, peuvent s'ajouter des déphasages dynamiques, typiquement de balance et de moiré, qui permettent de corriger des défauts sur le moniteur dûs au signal de commande HDRIVE.

Le circuit qui gère ces déphasages est programmable, recevant des commandes externes de déphasage dynamique en provenance d'autres circuits du moniteur, de la même manière que l'information HPOS.

En pratique, pour que ces corrections de déphasage dynamiques soient correctement traitées, le circuit de calcul numérique doit déplacer en conséquence la position donnée par l'information HFLYPOSREFC, de la valeur de ces corrections de déphasage dynamiques, afin de conserver l'équilibre de la boucle PLL₂.

Ce circuit de calcul fournit donc en sortie le déphasage à obtenir. Quand la boucle est équilibrée, il s'agit du déphasage donné par HPOS - Δ, plus les corrections dynamiques éventuelles.

Ce déphasage comprend une valeur grossière DEPHG et une partie fine DEPHF. La valeur grossière DEPHG indique le décalage à faire en nombre de cycles de 5.2 nanosecondes. Dans l'exemple, elle est codée sur 14 bits. La valeur fine DEPHF indique le décalage fin à effectuer en nombre de pas de 325 picosecondes. Dans l'exemple elle est codée sur 4 bits, permettant un déphasage de 0 à 15 pas de 325 ps (16x325 ps = 5.2 ns).

Le déphasage grossier est obtenu classiquement au moyen d'un compteur 20 à préchargement, qui dans l'exemple fonctionne en décomptage.

Ce compteur 20 reçoit le signal H2 sur l'entrée de déclenchement du décomptage CE. La valeur de déphasage grossier DEPHG est appliquée sur l'entrée de préchargement LOAD. Le signal d'horloge PHIREF (192 Mhz) est lui appliqué en entrée horloge CK du compteur.

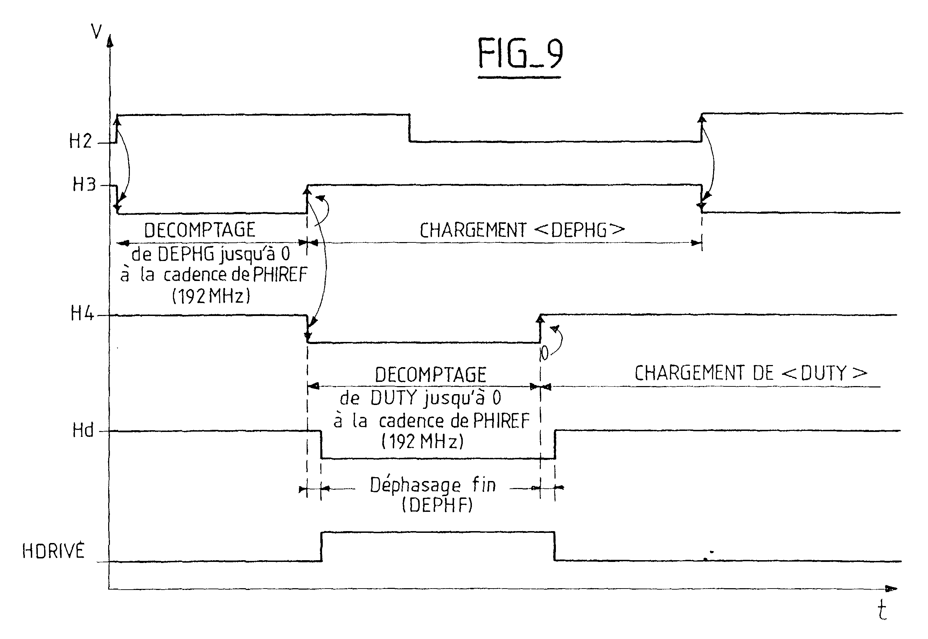

Le fonctionnement de ce compteur est représenté sur la figure 9.

Le front montant du signal recalé H2 déclenche le décomptage. Ce déclenchement fait passer à zéro un signal de validation interne, nommé H3.

Le compteur 20 décompte à partir de la valeur préchargée DEPHG, jusqu'à zéro. La détection du zéro dans le compteur fait repasser le signal de validation interne H3 à un, correspondant à un état de préchargement de la valeur de déphasage grossier DEPHG et d'attente du prochain front montant du signal H2.

Le signal de validation interne H3 est le signal de sortie, dont le front montant est correctement décalé par rapport au front montant du signal H2, de la valeur DEPHG.

Ce signal H3 va servir comme signal de déclenchement du décomptage d'un circuit d'adaptation du rapport cyclique. C'est un autre compteur à préchargement 21 qui reçoit le signal H3 sur son entrée CE de déclenchement du décomptage, la phase fixe PHIREF sur son entrée horloge CK et qui reçoit, comme valeur de préchargement, une information DUTY, programmée par l'application, et qui permet en pratique de régler le rapport cyclique entre 35 et 65%. Le fonctionnement de ce compteur 21 est identique au compteur 20 précédent. Le signal de sortie H4 est le signal de validation interne correspondant et il est représenté sur la Figure 9. On retrouve la phase de décomptage jusqu'à zéro et la phase de chargement de la valeur DUTY et d'attente du prochain front montant du signal H2.

Ce signal H4 est appliqué en entrée d'un circuit de déphasage fin 22.

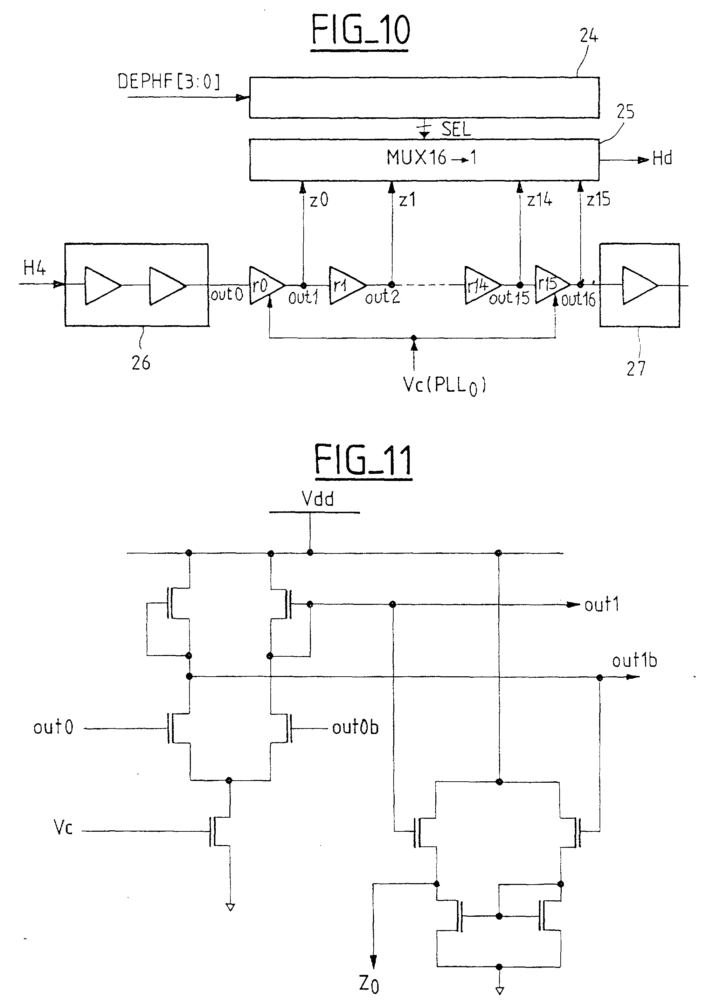

Le circuit de déphasage fin utilisé dans l'invention est schématisé sur la figure 10. Selon l'invention, ce circuit comprend une chaîne de cellules à retard commandées par la tension de commande Vc de la boucle analogique PLL₀.

Le signal H4 est appliqué en entrée à une chaîne de cellules à retard r0 à r15 en série, toutes identiques, introduisant chacune un retard de 325 picosecondes.

Un étage d'entrée 26 et un étage de sortie 27 est prévu qui permet d'équilibrer cette chaîne. Ils introduisent un retard fixe, de l'ordre de 3 ns.

La précision est obtenue en pratique en utilisant pour chaque cellule, un inverseur commandé en tension, dont un exemple de réalisation est représenté sur la figure 11. La tension de commande est la tension Vc fournie par le circuit de boucle à verrouillage de phase ALL₀. Cette cellule fournit un signal de sortie z0 décalé de 325 ps.

Les signaux de sortie z0 et z15 sont appliqués directement en entrée d'un multiplexeur 16 voies vers une, référencé 25 sur la figure. Il est commandé par un encodeur 24, qui fournit l'information SEL de sélection de la voie, sur 16 bits, en fonction des 4 bits de la valeur de déphasage fin à effectuer. On obtient en sortie un signal Hd correctement déphasé.

Ce signal Hd est appliqué à un circuit RF qui fournit le signal HDRIVE attendu en sortie et envoyé au moniteur. Ce circuit permet de changer la polarité du signal HDRIVE par rapport au signal Hd, en fonction de l'application. C'est ce circuit qui remet en forme le signal HFLY renvoyé par le moniteur, pour fournir le signal HFLYDSP utilisé en interne par la boucle PLL₂.

L'invention qui vient d'être décrite ne se limite pas aux exemples de réalisation détaillés. En particulier, on pourrait utiliser un comptage au lieu d'un décomptage dans le circuit de mesure ou le circuit de déphasage. L'invention ne se limite pas non plus aux conventions de logique utilisée. Par exemple, on pourrait très bien utiliser des fronts descendants comme signaux de déclenchement. Toutes ces variations restent dans le domaine de l'invention.

L'invention couvre aussi bien l'utilisation du signal de commande que celle d'un signal de commande dérivé, décalé en interne dans la boucle à verrouillage de phase, ces variantes dépendant de l'application concernée.

## Revendications

1. Dispositif de génération d'un signal de commande (HDRIVE) déphasé par rapport à un signal de synchronisation externe (HSYNC), comprenant une première boucle à verrouillage de phase numérique (PLL₁) pour fournir un signal de référence (PHI1) asservi au signal de synchronisation externe (HSYNC) par une phase courante parmi N phases (Fi0, ..,Fi15) d'un signal de haute fréquence (F), **caractérisé en ce qu'**il comprend une deuxième boucle à verrouillage de phase numérique (PLL₂) comprenant un circuit de mesure (CME) de la position d'un front actif du signal de commande (HDRIVE) ou d'un signal dérivé retardé (HFLYDSP) par rapport à un front actif du signal de référence (PHI1), un circuit de calcul du déphasage à effectuer (CCN) et un circuit de déphasage (CD), et en ce que le circuit de mesure (CME) comprend un circuit de mesure grossière (CMG) de ladite position, contrôlé par une phase fixe (PHIREF) du signal de haute fréquence (F) indépendante de la phase courante de la première boucle (PLL₁), le circuit de calcul numérique (CCN) comprenant des moyens pour prendre en compte le décalage entre ladite phase fixe (PHIREF) et ladite phase courante.

2. Dispositif selon la revendication 1, la première boucle (PLL₁) comprenant un synthétiseur de fréquence (3) pour fournir en sortie un signal synthétisé (CKGEN) et N phases correspondantes de ce signal (NF0,...,NF15) par division de fréquence des N phases du signal haute fréquence (F), **caractérisé en ce que** le circuit de mesure grossière (CMG) comprend des moyens (H2GEN) pour fournir un signal de référence recalé (H2) par rapport à une phase fixe (CKGENREF) parmi les N phases (NF0,...NF15) du signal synthétisé (CKGEN) correspondant à la phase fixe (PHIREF) du signal de haute fréquence (F) et un premier circuit de comptage à préchargement (14), préchargé à une valeur de position théorique (HFLYPOSREFC) fournie par le circuit de calcul numérique (CCN) et déclenché par un front actif du signal de référence recalé (H2), pour compter ou décompter à la cadence de la phase fixe de haute fréquence (CKGENREF), le comptage ou le décomptage étant inhibé par un front actif du signal de commande (HDRIVE) ou du signal dérivé (HFLYDSP), la sortie du compteur fournissant une première mesure grossière (MESG1).

3. Dispositif selon la revendication 2, **caractérisé en ce que** le circuit de mesure grossière comprend un deuxième circuit de décomptage (15), cadencé par la phase complémentaire (PHIREFB) de la phase fixe du signal de haute fréquence (F), qui fournit en sortie une deuxième mesure grossière (MESG2).

4. Dispositif selon la revendication 2 ou 3, **caractérisé en ce que** le circuit de mesure (CME) comprend en outre un circuit de mesure fine (CMF) comprenant des moyens pour mémoriser l'état des N phases (Fi0, ..Fi15) du signal de haute fréquence (F) sur un front actif du signal de commande (HDRIVE) ou du signal de commande dérivé (HFLYDSP), et des moyens (17, 18) pour déterminer la phase parmi ces N phases sur laquelle ledit front est arrivé, l'information correspondante fournissant la mesure fine attendue en sortie (MESF).

5. Dispositif selon la revendication 4, **caractérisé en ce que** le circuit de calcul numérique, fournit une information de déphasage grossier (DEPHG) et une information de déphasage fin (DEPHF) au circuit de déphasage (CD) en fonction des mesures grossières et fine fournies par le circuit de mesure (CME), d'une valeur programmée (HPOS) et d'une information (PHISELECT) identifiant la phase courante dans la première boucle (PLL₁).

6. Dispositif selon la revendication 5, **caractérisé en ce que** le circuit de calcul numérique (CCN) ces informations de déphasage grossier (DEPHG) de déphasage fin (DEPHF) sont en outre fonction de commandes externes de déphasage dynamique.

7. Dispositif selon la revendication 5 ou 6, **caractérisé en ce que** le circuit de déphasage comprend en plus un circuit de déphasage grossier (20) et un circuit de déphasage fin (22), pour fournir en sortie le signal de commande (HDRIVE) à partir du signal recalé (H2) et des informations de déphasage grossier et fin et un circuit programmable de correction du rapport cyclique (21).

8. Dispositif selon la revendication 7, les N phases (Fi0,..,Fi15) du signal haute fréquence (F) étant fournies par une boucle à verrouillage de phase analogique (PLL₀) comprenant un oscillateur commandé en tension (VCO) par une tension de commande (Vc), **caractérisé en ce que** le circuit de déphasage fin (22) comprend une chaîne de N cellules à retard (r0 à r15) commandés par ladite tension de commande (Vc).

9. Circuit de traitement des signaux de balayage horizontal dans un moniteur, **caractérisé en ce qu'**il comprend un dispositif selon l'une quelconque des revendications précédentes.

## Patentansprüche

1. Generator für ein Steuersignal (HDRIVE), das in bezug auf ein externes Synchronisationssignal (HSYNC) phasenverschoben ist, mit einem ersten digitalen Phasenregelkreis (PLL₁) für das Ausgeben eines Referenzsignals (PHI1), das von dem externen Synchronisationssignal (HSYNC) über eine momentane Phase von N Phasen (Fi0 - Fi15) eines Hochfrequenzsignals (F) abhängt,
**dadurch gekennzeichnet, daß**
er einen zweiten Phasenregelkreis (PLL₂) mit einem Meßschaltkreis (CME) für die Position einer aktiven Flanke des Steuersignals (HDRIVE) oder eines in bezug auf eine aktive Flanke des Referenzsignals (PHI1) abgeleiteten verzögerten Signals (HFLYDSP), einem Schaltkreis für die Berechnung der durchzuführenden Phasenverschiebung (CCN) und einem Phasenschieberschaltkreis (CD) umfaßt und daß der Meßschaltkreis (CME) einen Grobmeßschaltkreis (GMG) für diese Position umfaßt, der durch eine feste Phase (PHIREF) des Hochfrequenzsignals (F) unabhängig von der momentanen Phase des ersten Kreises (PLL₁) gesteuert wird, wobei der digitale Rechenschaltkreis (CCN) Vorrichtungen umfaßt, um die Verschiebung zwischen der festen Phase (PHIREF) und der momentanen Phase zu berücksichtigen.

2. Generator nach Anspruch 1, wobei der erste Kreis (PLL₁) einen Frequenz-Synthesizer (3) zum Ausgeben eines Synthesizer-Signals (CKGEN) und von N entsprechenden Phasen dieses Signals (NF0, ..., NF15) am Ausgang durch Frequenzteilung von N Phasen des Hochfrequenzsignals (F) umfaßt, **dadurch gekennzeichnet, daß** der Grobmeßschaltkreis (CMG) Vorrichtungen (H2GEN) umfaßt, um ein mit Bezug auf eine feste Phase (CKGENREF) unter den N Phasen (NF0 - NF 15) des Syntheszier-Signals (CKGEN) neu synchronisiertes Referenzsignal (H2) entsprechend der festen Phase (PHIREF) des Hochfrequenzsignals (F) auszugeben, und einen ersten Zählschaltkreis mit Aufladung (14) umfaßt, der mit einem theoretischen Positionswert (HFLYPOSREFC) aufgeladen ist, der durch den digitalen Rechenschaltkreis (CCN) ausgegeben wurde, und ausgelöst wird durch eine aktive Flanke des neu synchronisierten Referenzsignals (H2), um im Takt der festen Phase der Hochfrequenz (CKGENREF) aufwärts oder abwärts zu zählen, wobei die Aufwärtszählung oder die Abwärtszählung inhibiert wird durch eine aktive Flanke des Steuersignals (HDRIVE) oder des abgeleiteten Signals (HFLYDSP), wobei am Ausgang des Zählers ein erstes grobes Maß (MESG1) ausgegeben wird.

3. Generator nach Anspruch 2, **dadurch gekennzeichnet, daß** der Schaltkreis für das grobe Maß einen zweiten Abwärtszählerschaltkreis (15) umfaßt, der getaktet wird durch die komplementäre Phase (PHIREFB) der festen Phase des Hochfrequenzsignals (F), der am Ausgang ein zweites grobes Maß (MESG2) ausgibt.

4. Generator nach Anspruch 2 oder 3, **dadurch gekennzeichnet, daß** der Meßschaltkreis (CME) außerdem einen Feinmeßschaltkreis (CMF) mit Vorrichtungen zum Abspeichern des Zustands von N Phasen (Fi0 - Fi15) des Hochfrequenzsignals (F) bei einer aktiven Flanke des Steuersignals (HDRIVE) oder des abgeleiteten Steuersignals (HFLYDSP) und Vorrichtungen (17, 18) für das Bestimmen der Phase unter den N Phasen umfaßt, bei der die Flanke angekommen ist, wobei die entsprechende Information das am Ausgang erwartete feine Maß (MESF) ausgibt.

5. Generator nach Anspruch 4, **dadurch gekennzeichnet, daß** der digitale Rechenschaltkreis eine Information bezüglich der Phasengrobverschiebung (DEPHG) und eine Information bezüglich der Phasenfeinverschiebung (DEPHF) an den Phasenschieberschaltkreis (CD) in Abhängigkeit von groben Maßen und feinen Maßen, ausgegeben durch den Meßschaltkreis (CME), einem programmierten Wert (HPOS) und einer Information (PHISELECT), die die momentane Phase in dem ersten Kreis (PLL₁) identifiziert, ausgibt.

6. Generator nach Anspruch 5, **dadurch gekennzeichnet, daß** der digitale Rechenschaltkreis (CCN) diese Informationen bezüglich der Phasengrobverschiebung (DEPHG) und der Phasenfeinverschiebung (DEPHF) in Abhängigkeit von externen Befehlen bezüglich der dynamischen Phasenverschiebung bestimmt.

7. Generator nach Anspruch 5 oder 6, **dadurch gekennzeichnet, daß** der Phasenschieberschaltkreis außerdem einen Phasengrobschieberschaltkreis (20) und einen Phasenfeinschieberschaltkreis (22), um am Ausgang das Steuersignal (HDRIVE) ausgehend von dem neu synchronisierten Signal (H2) und Informationen zu der Phasengrob- und -feinverschiebung auszugeben, sowie einen programmierbaren Schaltkreis für die Korrektur des Dutycycles (21) umfaßt.

8. Generator nach Anspruch 7, wobei die N Phasen (Fi0 - Fi15) des Hochfrequenzsignals (F) ausgegeben werden durch einen analogen Phasenregelkreis (PLL₀) mit einem spannungsgesteuerten Oszillator (VCO), der durch eine Steuerspannung (Vc) gesteuert wird, **dadurch gekennzeichnet, daß** der Phasenfeinschieberschaltkreis (22) eine Kette von N Verzögerungszellen (r0 bis r15) umfaßt, die durch die Steuerspannung (Vc) gesteuert werden.

9. Signalverarbeitungsschaltkreis für die horizontale Abtastung in einem Monitor, **dadurch gekennzeichnet, daß** er eine Vorrichtung nach einem der vorangehenden Ansprüche umfaßt.

## Claims

1. Device for generating a drive signal (HDRIVE) phase-shifted with respect to an external synchronisation signal (HSYNC), comprising a first digital phase-lock loop (PLL₁) for supplying a reference signal (PHI1) slaved to the external synchronisation signal (HSYNC) by one current phase from among N phases (Fi0, ..., Fi15) of a high-frequency signal (F), **characterised in that** it comprises a second digital phase-lock loop (PLL₂) comprising a circuit (CME) for measuring the position of an active edge of the drive signal (HDRIVE) or of a derived signal (HFLYDSP) delayed with respect to an active edge of the reference signal (PHI1), a circuit for calculating the phase shift to be applied (CCN) and a phase-shift circuit (CD), and in that the measuring circuit (CME) comprises a circuit for coarse measuring (CMG) of the said position, controlled by a fixed phase (PHIREF) of the high-frequency signal (F), this phase being independent of the current phase of the first loop (PLL₁), the digital calculating circuit (CCN) comprising means for taking account of the offset between the said fixed phase (PHIREF) and the said current phase.

2. Device according to Claim 1, the first loop (PLL₁) comprising a frequency synthesiser (3) for supplying, as output, a synthesised signal (CKGEN) and N corresponding phases of this signal (NF0, ..., NF15) by frequency-division of the N phases of the high-frequency signal (F), **characterised in that** the coarse-measuring circuit (CMG) comprises means (H2GEN) for supplying a reference signal (H2) readjusted with respect to one fixed phase (CKGENREF) from among the N phases (NF0, ... NF15) of the synthesised signal (CKGEN) corresponding to the fixed phase (PHIREF) of the high-frequency signal (F) and a first counting circuit with pre-loading (14), preloaded to a theoretical position value (HFLYPOSREFC) supplied by the digital calculating circuit (CCN) and triggered by an active edge of the readjusted reference signal (H2), in order to count or count down at the clock rate of the fixed, high-frequency phase (CKGENREF), the counting or the down-counting being inhibited by an active edge of the drive signal (HDRIVE) or of the derived signal (HFLYDSP), the output of the counter supplying a first coarse measurement (MESG1).

3. Device according to Claim 2, **characterised in that** the coarse-measuring circuit comprises a second down-counting circuit (15), clocked by the complementary phase (PHIREFB) of the fixed phase of the high-frequency signal (F), which supplies a second coarse measurement (MESG2) as output.

4. Device according to Claim 2 or 3, **characterised in that** the measuring circuit (CME) further comprises a fine-measuring circuit (CMF) comprising means for memory-storage of the state of the N phases (Fi0, ... Fi15) of the high-frequency signal (F) on an active edge of the drive signal (HDRIVE) or of the derived drive signal (HFLYDSP), and means (17, 18) for determining the phase from among these N phases on which the said edge has arrived, the corresponding information supplying the fine measurement awaited at the output (MESF).

5. Device according to Claim 4, **characterised in that** the digital calculating circuit supplies coarse-phase-shift information (DEPHG) and fine-phase-shift information (DEPHF) to the phase-shift circuit (CD) as a function of the coarse and fine measurements supplied by the measuring circuit (CME), of a programmed value (HPOS) and of information (PHISELECT) identifying the current phase in the first loop (PLL₁).

6. Device according to Claim 5, **characterised in that**, in the digital calculating circuit (CCN), this coarse-phase-shift information (DEPHG) and fine-phase-shift (DEPHF) information is, moreover, a function of external, dynamic phase-shift commands.

7. Device according to Claim 5 or 6, **characterised in that** the phase-shift circuit further comprises a coarse-phase-shift circuit (20) and a fine-phase-shift circuit (22), for supplying, as output, the drive signal (HDRIVE) on the basis of the readjusted signal (H2) and of coarse- and fine-phase-shift information, and a programmable circuit for correcting the duty cycle (21).

8. Device according to Claim 7, the N phases (Fi0, ..., Fi15) of the high-frequency signal (F) being supplied by an analogue phase-lock loop (PLL₀) comprising a voltage-controlled oscillator controlled by a control voltage (Vc), **characterised in that** the fine-phase-shift circuit (22) comprises a chain of N delay cells (r0 to r15) controlled by the said control voltage (Vc).

9. Circuit for processing horizontal-scanning signals in a monitor, **characterised in that** it comprises a device according to any one of the preceding claims.
